# EUROPEAN PATENT APPLICATION

(11) **EP 1 930 958 A2**
(43) Date of publication of application: **11.06.2008**
(21) Application number: 07023453.9
(22) Date of filing: 04.12.2007
(51) Int. Cl.: H01L 33/00

(54) **Light emitting diode package, and light source unit and backlight unit including the same**

(30) Priority: 05.12.2006 KR 20060121956
(71) Applicant: Samsung Electronics Co., Ltd., Yeongtong-gu Suwon-city, Gyeonggi-do 442-742 (KR)
(72) Inventor: Shin, Dong-Lyoul, Suwon-si Gyeonggi-Do (KR); Chun, Hyo-Suck, Suwon-si Gyeonggi-Do (KR); Choi, Jae-Jin, Seoul (KR); Kwak, Yong-Seok, Seongnam-si Gyeonggi-Do (KR); Kim, Dae-Seop, Anseong-si Gyeonggy-Do (KR)
(74) Representative: Schmidt, Sven Hendrik

(57) **Abstract**

The light emitting diode ("LED") package includes at least one LED chip which emits light, a housing defining a space for receiving the at least one LED chip, and the housing including a light emitting surface which collects the light emitted from the at least one LED chip and emits the same to an external environment and a lead portion, penetrating a lower surface of the housing, one end of the lead portion is electrically connected to the at least one LED chip in the housing and another end of the lead portion is exposed to the external environment.

## Description

This application claims priority to Korean Patent Application No. 2006-0121956, filed on December 5, 2006, and all the benefits accruing therefrom under 35 U.S.C. §119, the contents of which in its entirety are herein incorporated by reference.

### BACKGROUND OF THE INVENTION

### 1. Field of the Invention

The present invention relates to a liquid crystal display ("LCD") device and, more particularly, to a light emitting diode ("LED") package that can reduce an outer size of an LCD panel by minimizing a generation of hot spots and a distance of a blind area, and a light source unit and a backlight unit including the LED package.

### 2. Description of the Related Art

In general, an LCD device displays an image using electrical and optical characteristics of liquid crystal. Due to advantages of the LCD device, such as compactness and lightness, as compared with a cathode ray tube ("CRT"), LCD devices are used in various applications such as portable computers, communication equipments, liquid crystal televisions and the like.

The LCD device includes a liquid crystal control unit for controlling the liquid crystal and a light source unit for supplying light to the liquid crystal, Typically, the LCD device may include an LCD panel as the liquid crystal control unit and a backlight unit as the light source unit.

The backlight unit includes a plurality of light sources which generate light and optical sheets, including a light guide plate for guiding the light in order to provide a planar light to the LCD panel. Typically, the light source includes a cold cathode fluorescent lamp ("CCFL") having a cylindrical shape or a light emitting diode ("LED") having a dot shape.

The backlight unit using the LEDs includes a plurality of LED packages sequentially mounted on an LED board, and which displays red (R), green (G) and blue (B) colors, respectively. Each LED package consists of an LED chip which emits light toward the light guide plate at a predetermined angle. Here, the light emitted from the LED package overlaps the light emitted from adjacent LED packages which thereby creates "hot spots" that are displayed brighter than a peripheral area.

Accordingly, a blind area is formed in the light guide plate from the LED package to a specific area wherein the hot spots are created, and thereby a portion of the light guide plate becomes a non-display area. Moreover, the adjacent LED packages have a specific distance from each other in order to ensure a sufficient space required for a soldering process. Accordingly, an outer size of the display device becomes relatively larger and a brightness of the light decreases.

### BRIEF SUMMARY OF THE INVENTION

The present invention has been made in an effort to solve the above stated problems, and it is an aspect of the present invention to provide an LED package which can reduce an outer size of an LCD panel by minimizing a generation of hot spots and a distance of a blind area, and a light source unit and a backlight unit including the LED package.

In accordance with an exemplary embodiment of the present invention, there is provided a light emitting diode ("LED") package including at least one LED chip which emits light, a housing defining a space for receiving the at least one LED chip, and the housing including a light emitting surface which collects the light from the at least one LED chip and emits the same to an external environment and a lead portion penetrating a lateral surface of the housing, one end of the lead portion is electrically connected to the at least one LED chip in the housing and another end of the lead portion is exposed to the external environment.

In an exemplary embodiment, the light emitting surface may occupy more than about 95% of an entire lateral surface area of the housing.

In an exemplary embodiment, the LED package of the present invention may further include a wavelength conversion layer formed to cover the at least one LED chip in the housing and which generates white light using light emitted from the at least one LED chip.

In an exemplary embodiment, the at least one LED chip may include red and blue light emitting diodes, and the wavelength conversion layer may include a green fluorescent material.

In an exemplary embodiment, the at least one LED chip may include at least one blue light emitting diode, and the wavelength conversion layer may include a yellow fluorescent material.

In an exemplary embodiment, the lead portion has a shape selected from the group consisting of an " I " shape, a "T" shape, a "Z" shape and a combination including at least one of the foregoing shapes.

In accordance with another exemplary embodiment of the present invention, there is provided a light source unit including a light emitting diode ("LED") board having an electrode pad for applying a driving voltage, a housing mounted on the LED board, the housing defining a space for receiving a plurality of LED chips which emits light, and the housing including a light emitting surface which collects the light emitted from the plurality of LED chips and emits the same to an external environment and a lead portion penetrating a lateral surface of the housing, one end of the lead portion is electrically connected to the plurality of LED chips in the housing and another end of the lead portion is exposed to the external environment.

In an exemplary embodiment, a plurality of LED packages is formed to be in contact with each other on the LED board.

In an exemplary embodiment, a single LED package is mounted on the LED board.

In an exemplary embodiment, the LED package is formed with a same size as the LED board.

In accordance with another exemplary embodiment of the present invention, there is provided a backlight unit including a light source unit including a LED board having an electrode pad for applying a driving voltage, a housing mounted to the LED board, defining a space for receiving a plurality of LED chips which emit light, and the housing including a light emitting surface which collects the light from the plurality of LED chips and emits the same to an external environment and a lead portion penetrating a lateral surface of the housing, one end of the lead portion is electrically connected to the plurality of LED chips in the housing and another end of the lead portion is exposed to the external environment and a light guide plate which converts a linear light emitted from the light source unit into a planar light.

In an exemplary embodiment, the light emitting surface of the housing is arranged to face the light guide plate.

In an exemplary embodiment, a plurality of LED packages is formed to be in contact with each other on the LED board.

In an exemplary embodiment, one side of the LED package includes a same length as a short side of the light guide plate.

### BRIEF DESCRIPTION OF THE DRAWINGS

The above and/or other aspects, features and advantages of the present invention will now become more apparent from the following detailed description when taken in conjunction with the accompanying drawings, in which:
FIG. 1 is an exploded front perspective view illustrating an exemplary embodiment of a liquid crystal display ("LCD") device including light emitting diode ("LED") packages according to a first exemplary embodiment of the present invention;
FIGS. 2A through 2C are enlarged front perspective views of portion "A" illustrated in FIG. 1 according to exemplary embodiments of the present invention;
FIG. 3A is a top plan view illustrating an exemplary embodiment of a light source unit according to a first exemplary embodiment of the present invention;
FIG. 3B is a top plan view illustrating an exemplary embodiment of a light source unit according to a second exemplary embodiment of the present invention;
FIG. 3C is a top plan view illustrating an exemplary embodiment of a light source unit according to a third exemplary embodiment of the present invention;
FIG. 4 is a front perspective view illustrating an exemplary embodiment of a LED package according to the present invention;
FIG. 5A is a cross-sectional schematic diagram view taken along line I-I' of FIG. 4 according to an exemplary embodiment of the present invention;
FIG. 5B is a cross-sectional schematic diagram view taken along line I-I' of FIG. 4 according to another exemplary embodiment of the present invention; and
FIG. 5C is a cross-sectional schematic diagram view taken along line I-I' of FIG. 4 according to another exemplary embodiment of the present invention.

### DETAILED DESCRIPTION OF THE INVENTION

The invention will now be described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting of the invention. As used herein, the singular forms "a", "an" and "the" are intended to include the plural forms as well, unless the context clearly indicates otherwise, It will be further understood that the terms "comprises" and/or ''comprlsing," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Spatially relative terms, such as "beneath", "below", "lower", "above", "upper" and the like, may be used herein for ease of description to describe one element or feature's relationship to another element(s) or feature(s) as illustrated in the figures, It will be understood that the spatially relative terms are intended to encompass different orientations of the device in use or operation in addition to the orientation depicted in the figures, For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein. Exemplary embodiments of the present invention are described herein with reference to cross section illustrations that are schematic illustrations of idealized embodiments of the present invention. As such, variations from the shapes of the illustrations as a result, for example, of manufacturing techniques and/or tolerances, are to be expected. Thus, embodiments of the present invention should not be construed as limited to the particular shapes of regions illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present invention.

Hereinafter, the present invention will be described in detail with reference to the accompanying drawings.

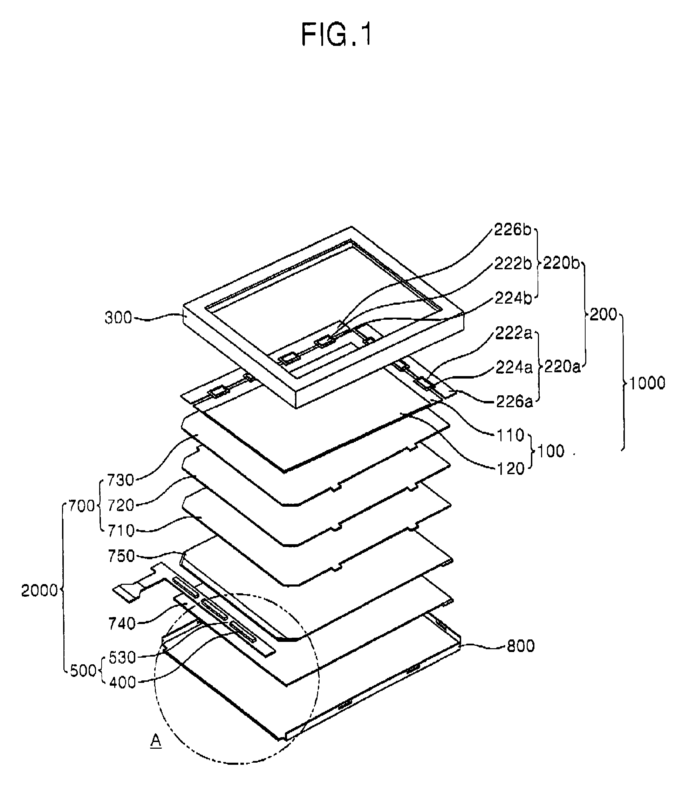

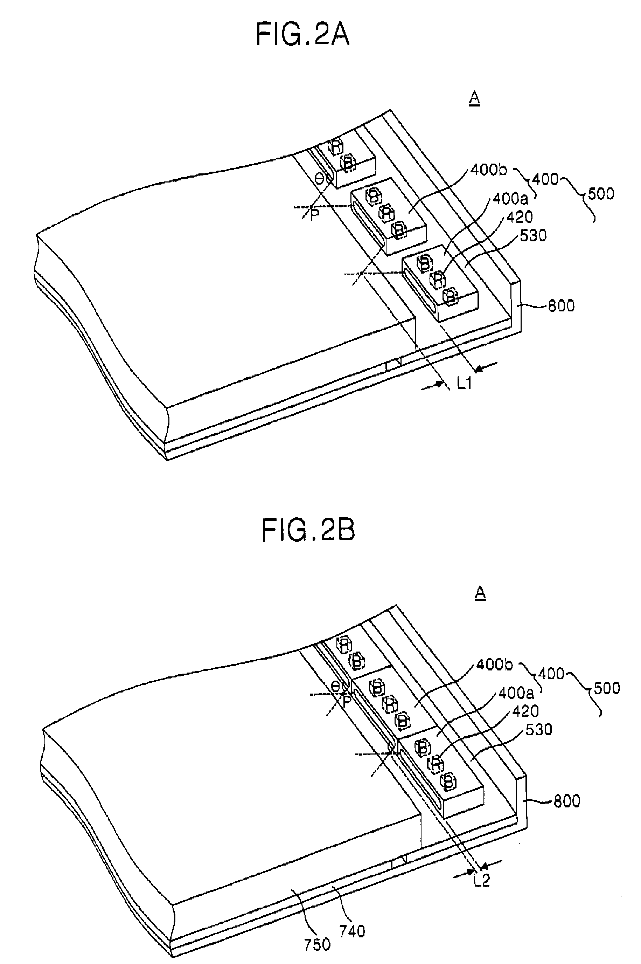

FIG. 1 is an exploded front perspective view illustrating an exemplary embodiment of a liquid crystal display ("LCD") device including light emitting diode ("LED") packages according to a first embodiment of the present invention, and FIGS. 2A through 2C are enlarged front perspective views of portion "A" illustrated in FIG. 1,

Referring to FIGS. 1 through 2C, an LCD device including LED packages according to the first exemplary embodiment of the present invention includes an upper receiving member 300, a lower receiving member 800, a display assembly 1000 which is seated in the upper receiving member 300 and a backlight assembly 2000 which is seated in the lower receiving member 800.

The upper receiving member 300 is made in a form of a rectangular frame including a plane portion and lateral portions which are bent perpendicularly to the plane portion so as to fix and cover elements of the display assembly 1000 and also to protect an LCD panel 100 and the backlight assembly 2000 from an impact applied from an external environment. In exemplary embodiments, the upper receiving member 300 may be formed to cover the entire backlight assembly 2000, including the LCD panel 100, or a portion of the backlight assembly 2000.

The lower receiving member 800 includes a rectangular parallelepiped box shape, of which an upper surface is opened, to thereby define a receiving space including a predetermined depth. The lower receiving member 800 includes a bottom surface and side walls which extend vertically from respective edges of the bottom surface. LED packages 400 are arranged in an inner side of two side walls facing each other of the lower receiving member 800. In an exemplary embodiment, the lower receiving member 800 is made of aluminum in order to protect the LED packages 400 from an impact from the external environment and to uniformly distribute heat so as to provide a cooling effect.

The display assembly 1000 includes an LCD panel 100 and a driving unit 200.

The LCD panel 100 includes a color filter substrate 110 and a thin film transistor ("TFT") substrate 120. The color filter substrate 110 includes a color filter including red, green and blue ("RGB") color pixels formed by a thin film process in which a specific color is displayed when light passes through the color filter. In exemplary embodiments, a common electrode (not shown) including a transparent conductive material such as an indium tin oxide ("ITO"), an indium zinc oxide ("IZO"), or the like is formed on a front surface of the color filter substrate 110.

In exemplary embodiments, the TFT substrate 120 is a transparent insulating substrate such as glass or plastic, on which a plurality of gate lines (not shown), a plurality of data lines (not shown) which intersect the plurality of gate lines, a plurality of TFTs which are arranged at intersections between the gate lines and the data lines and a plurality of pixel electrodes (not shown) which are connected to the TFTs are formed.

The gate line and the data lines cross each other with insulation layers disposed therebetween. The gate lines supply gate driving voltages including gate-on and gate-off voltages to gate electrodes of the TFTs, and the data lines supply pixel voltages to source electrodes of the TFTs.

Each TFT includes a gate electrode connected to a corresponding gate line, a source electrode connected to a corresponding data line, a drain electrode separated from the source electrode and connected to a pixel electrode and a semiconductor layer formed between the gate electrode and the source and drain electrodes. The TFT is turned on when the gate-on voltage is applied to the gate electrode in order to charge a pixel voltage which is supplied through the data line connected to the source electrode to the pixel electrode through the drain electrode.

The driving unit 200 includes a gate driving unit 220a which is connected to a short side of the LCD panel 100 and which drives the gate lines, and a data driving unit 220b which is connected to a long side of the LCD panel 100 and which drives the data lines.

The gate driving unit 220a includes a gate driving circuit 222a mounted on a gate tape carrier package ("TCP") 224a and connected to the LCD panel 100 and a gate circuit board 226a or mounted on the TFT substrate 120 in the form of a chip-on-glass ("COG"). In exemplary embodiments, the gate driving unit 220a may be integrated into the TFT substrate 120 in the form of an amorphous silicon gate ("ASG"), According to the current exemplary embodiment, a description will be given by citing an example in which the gate driving circuit 222a is mounted on the gate TCP 224a.

The data driving unit 220b includes a data driving circuit 222b mounted on a data TCP 224b and connected to the LCD panel 100, and a data circuit board 226b.

The backlight assembly 2000 includes a plurality of LED packages 400, a light guide plate 750 which is arranged adjacent to the LED packages 400, a reflection sheet 740 which is arranged on a rear surface of the light guide plate 750 and a plurality of optical sheets 700 which are arranged on an upper surface of the light guide plate 750.

The light guide plate 750, which is seated in the lower receiving member 800, converts light including an optical distribution in the form of a linear light source generated from each of the plurality of LED packages 400 into light including an optical distribution in the form of a planar light source. In exemplary embodiments, the light guide plate 750 may be made of polymethylmethacrylate ("PMMA") including a high strength in order not to be easily transformed or broken and also including a high transmissivity.

In exemplary embodiments, the reflection sheet 740 is made of a plate including a high reflectivity in order to reflect incident light toward the light guide plate 750 to thereby reduce a loss of light. The reflection sheet 740 is arranged to be in contact with the bottom surface of the lower receiving member 800. Moreover, in exemplary embodiments, if the bottom surface of the lower receiving member 800 is coated with a material including a high reflectivity, the reflection sheet 740 may be omitted or formed integrally with the lower receiving member 800.

The optical sheet 700 includes a diffusion sheet 710, a prism sheet 720 and a polarizing sheet 730, which are sequentially arranged on the upper surface of the light guide plate 750 in order to make the luminance distribution of light emitted from the light guide plate 750 uniform. The diffusion sheet 710 orientates incident light from the light guide plate 750 toward the LCD panel 100 and diffuses light which is to be irradiated onto the LCD panel 100 with a uniform distribution in a wide range. In exemplary embodiments, the diffusion sheet 710 may be made of a transparent resin film coated with a specific light-diffusion material on both sides. The prism sheet 720 redirects light incident at an inclined angle to be substantially perpendicular to an upper surface of the polarizing sheet 730. The reason for this is that an optical efficiency increases when light is irradiated onto the LCD panel 100 in a perpendicular direction to the LCD panel 100. Accordingly, in exemplary embodiments, at least one prism sheet 720 may be arranged on a bottom side of the LCD panel 100 in order to redirect the light emitted from the diffusion sheet 710 into the perpendicular direction.

The light source unit 500 includes the LED packages 400 and an LED board 530, on which the LED packages 400 are mounted.

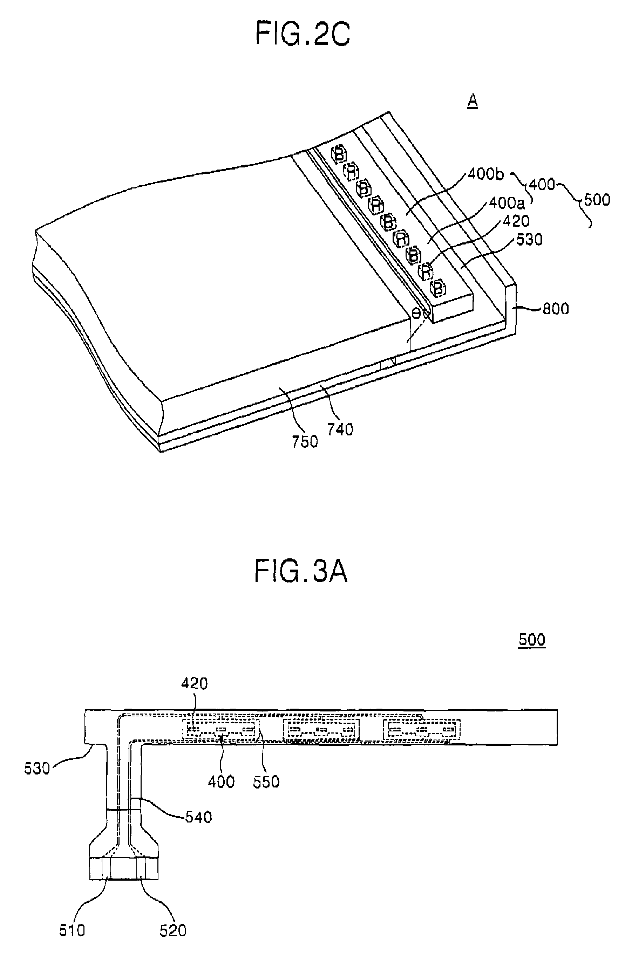

The LED packages 400 will be described in more detail with reference to FIGS. 2A through 2C and the LED board 530 will be described in more detail with reference to FIGS. 3A through 3C, respectively,

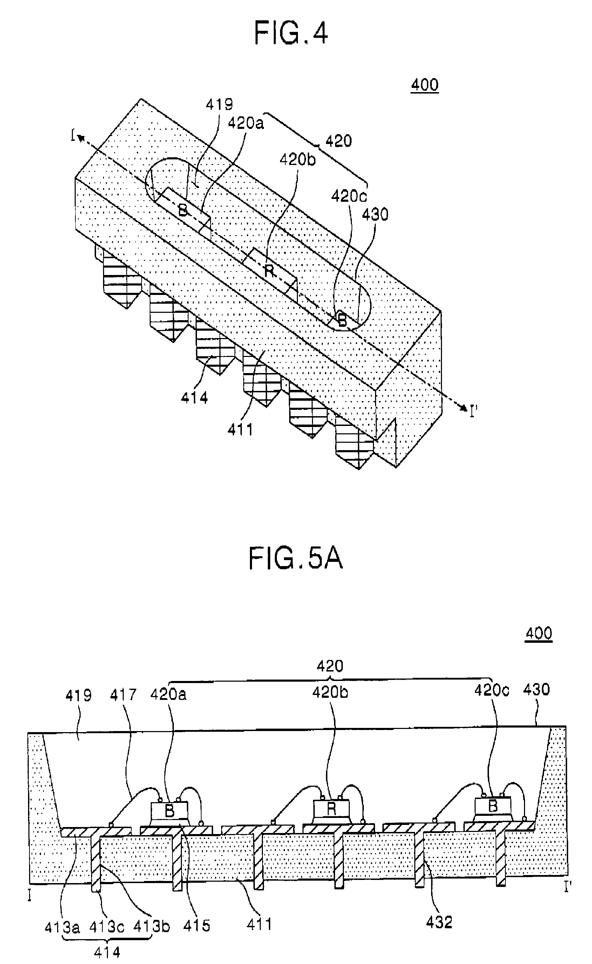

In exemplary embodiments, the LED packages 400 may be mounted on one or both of the short sides of the light guide plate 750. The LED board 530 includes an electrode pad 550 which is connected to lead portions 414 of the LED package 400 (see FIG. 4). The LED board 530 includes a plurality of driving signal lines 540 which extends from the electrode pad 550 and which supplies driving signals to drive the LED packages 400. Each driving signal line 540 of the plurality of driving signal lines 540 is supplied with an anode pad 510 and a cathode pad 520 which are connected to the electrode pad 550, respectively.

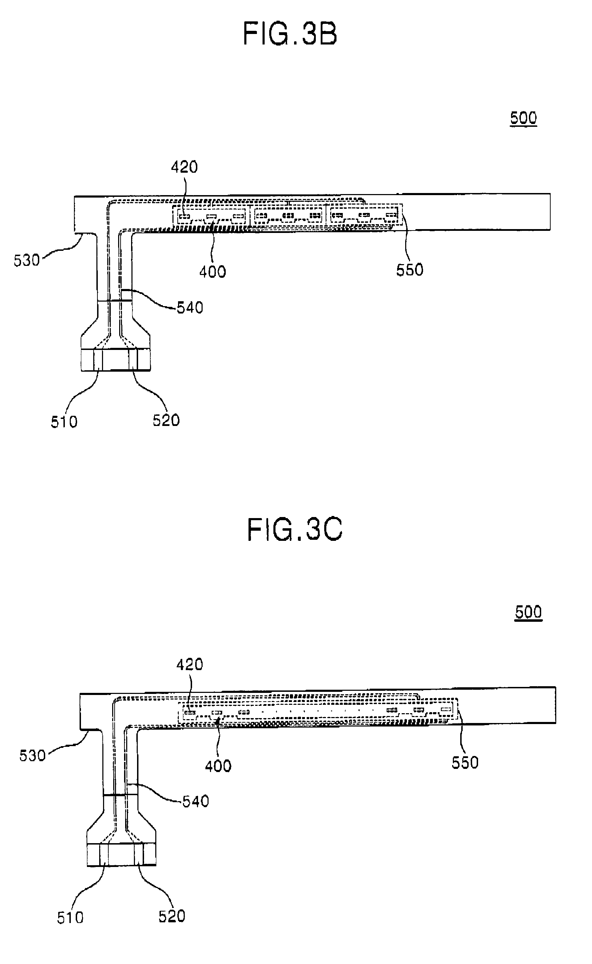

As shown in FIGS. 2A and 3A, in an exemplary embodiment, a first LED package 400a which is provided on one of the short sides of the light guide plate 750 may be arranged adjacent to a second LED package 400b spaced apart from each other at a predetermined interval or, as shown in FIGS. 2B an 3B, the first LED package 400a may be arranged to be in contact with the second LED package 400b. In alternative exemplary embodiments, as shown in FIGS. 2C and 3C, the LED package 400 may be integrally formed as a single LED package 400 and which includes a same length as the short side of the light guide plate 750. In the current exemplary embodiment, each LED package 400 includes a plurality of LED chips 420 which generate light.

In more detail, the first LED package 400a is arranged adjacent to the second LED package 400b, and adjacent LED packages are spaced apart from each other at a predetermined interval so as to exclude a space required for a soldering process, as shown in FIG. 2A. In alternative exemplary embodiments, the first LED package 400a is arranged to be in contact with the second LED package 400b, as shown in FIG. 2B. In the current exemplary embodiment, a distance between the two adjacent LED packages 400 may be set in a range of about 0 to about 0.2 mm. In alternative exemplary embodiments, the LED package 400, as shown in FIG. 2C, is integrally formed as a single LED package 400 and includes a same length as the LED board 530 and the light guide plate 750, which is disposed on the LED board 530.

Light emitted from the respective LED packages 400 include a predetermined angle θ. The light emitted at the predetermined angle θ overlaps light emitted from adjacent LED packages 400 which emit light at the same predetermined angle θ, which thereby causes hot spots. A distance between the hot spots may be decreased as much as the interval between the LED packages 400 is reduced. That is, the light emitted at a predetermined angle θ from the respective LED packages 400 which are arranged to be spaced apart from each other at predetermined intervals, as shown in FIG. 3A, overlap each other at a predetermined distance to thereby cause the hot spots.

A distance L1 between the hot spots and the LED packages 400 which are arranged to be spaced apart from each other at a predetermined interval, as shown in FIG. 2A, is larger than a distance L2 between hot spots and the LED packages 400 which are arranged to be in contact with each other, as shown in FIG. 2B. Moreover, as shown in FIG. 2C, the light emitted at a predetermined angle θ from the LED packages 400 which is integrally formed as a single LED package 400 and which includes the same length as the one side of the light guide plate 750 or the short side of the LED board 530, does not cause any hot spots. In an exemplary embodiment, the predetermined angle may be about 110°.

As described above, according to an exemplary embodiment of an LCD device according to the present invention, it is possible to minimize a distance of the hot spots generated between the existing LED packages 400 or prevent a generation of the hot spots by minimizing or eliminating the interval between the LED packages 400, and thereby reducing an outer size of the LCD panel 100 of the LCD device.

The light emitted from the respective LED packages 400 overlap each other within a distance of about 0.49 mm along the interval between the LED packages 400 and thereby it is possible to reduce the size of the LCD panel 100 and the blind area caused by the hot spots.

FIG. 4 is a front perspective view illustrating an exemplary embodiment of a LED package according to the present invention, and FIGS. 5A through 5C are cross-sectional schematic diagram views taken along line I-I' of FIG. 4.

Referring to FIGS. 4 through 5C, the LED package 400 includes an LED chip 420 which generates first to third light sources 420a, 420b and 420c, a wavelength conversion layer 419, a housing 411 and lead portions 414.

The LED chip 420 includes the first to third light sources 420a, 420b and 420c which emit a blue light (B), a red light (R) and a blue light (B), respectively. The LED chip 420 is mounted on the lead portions 414 using a conductive adhesive 415 and is driven by driving voltages which are applied to the lead portions 414 through pairs of conductive wires 417. Although the red (R) and blue (B) light sources are depicted in FIG. 4, the present invention is not limited thereto, but may be possible to adopt an LED chip including red (R), green (G) and blue (B) light sources or including all blue (B) light sources. In exemplary embodiments, at least one LED chip 420 may be included in a single LED package 400.

The wavelength conversion layer 419 mixes light emitted from the LED chip 420 in order to generate a white light. That is, when the driving voltages are applied to the first to third light sources 420a, 420b and 420c through the respective lead portions 414, the first to third light sources 420a, 420b and 420c generate first-order lights, including corresponding peak wavelengths, respectively. The generated first-order lights are excited by the wavelength conversion layer 419 and a portion of the first-order lights is wavelength-canverted into a second-order light. At this time, the first-order light emitted from the first to third light sources 420a, 420b and 420c and the second-order light wavelength-converted by the wavelength conversion layer 419 are mixed together in order to generate the white light in a range of a visible light spectrum. In exemplary embodiments, the wavelength conversion layer 419 may include a fluorescent material or a mixture of fluorescent materials. In exemplary embodiments, if the LED chip 420 includes red and blue light sources, the wavelength conversion layer 419 may be made of a yellow fluorescent material, whereas, if the LED chip 420 includes blue light sources, the wavelength conversion layer 419 may be made of a green fluorescent material.

The housing 411 is a body of the LED package 400 and defines a space which receives the first to third light sources 420a, 420b and 420c, the wavelength conversion layer 419 and the lead portions 414. The housing 411 includes a light emitting surface 430 which light radiates from and a plurality of through-holes 432 which the lead portions 414 are inserted into and project from.

The light emitting surface 430 is an element which guides the light generated from the LED chip 420 toward an external environment and is formed on an upper surface of the housing 411. The housing 411 is in contact with the LED board 530. As shown in FIG. 2A through 2C, the LED board 530 faces the light guide plate 750. In exemplary embodiments, the light emitting surface 430 is formed to occupy about 90 to 100% of a longitudinal side of the upper surface of the housing 411. In an exemplary embodiment, the light emitting surface 430 is formed to occupy more than about 95% of the upper surface of the housing 411.

The through-holes 432 are formed on a surface substantially perpendicular to the upper surface of the housing 411 on which the light emitting surface 430 is formed, e.g., the lateral surface of housing 411 which is in contact with the LED board 530. The through-holes 432 allow the lead portions 414 to penetrate from an inner side of the housing 411 to an outer side of the housing 411. A number of the through-holes 432 corresponds to a number of the lead portions 414.

The lead portions 414 are electrodes which supply the driving voltage to the LED chip 420 and are formed to penetrate the lower surface of the housing 411 through the through-holes 432. One end of each lead portion 414 is electrically connected to at least one of the first to third light sources 420a, 420b and 420c disposed in the housing 411 and the other end of each lead portion 414 is exposed to the external environment of the housing 411. In the current exemplary embodiment, the lead portions 414 are alternately arranged such that a cathode lead is adjacent to two anode leads. That is, the cathode leads and the anode leads are arranged alternately and connected to each other by a pair of conductive wires 417, In this manner, each lead portion 414 including the cathode and anode leads is inserted into the through-hole 432 of the housing 411 and one end of each lead portion 414 is exposed to the external environment.

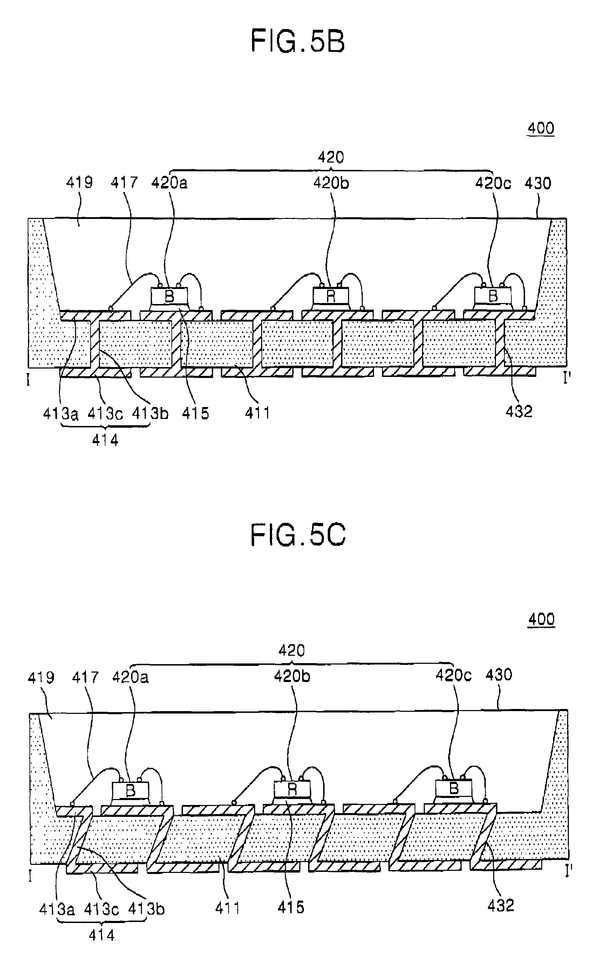

As shown in FIG. 5A, the lead portion 414 is formed in a shape of the letter "T," which includes a seat portion 413a seated in the housing 411, an insertion portion 413b inserted in order to penetrate the through-hole 432 of the housing 411 and a projection portion 413c which extends from the insertion portion 413b and is exposed to the external environment through the through-hole 432 in order to be connected to the electrode pad 550 of the LED board 530, as shown in FIGS. 3A and 3B. In alternative exemplary embodiments, as shown in FIG. 5B. the lead portion 414 is formed in a shape of the letter "I," which includes a seat portion 413a seated in the housing 411, an insertion portion 413b inserted in order to penetrate the through-hole 432 of the housing 411 and a contact portion 413c which is in contact with an outer surface of the housing 411. In further alternative exemplary embodiments, as shown in FIG. 5C, the lead portion 414 is formed in a shape of the letter "Z," which includes a seat portion 413a seated in the housing 411, an insertion portion 413b inserted to obliquely penetrate the through-hole 432 of the housing 411 and a contact portion 413c formed in a direction opposite to the seat portion 413a and which is in contact with the outer surface of the housing 411. However, the shape of the lead portion 414 of the present invention is not limited thereto, but may be modified in various forms in exemplary embodiments,

Since the LED package 400 of the present invention includes a plurality of through-holes 432, through which the lead portions 414 penetrate in order to be exposed to the rear surface of the housing 411 which is in contact with the LED board 530, a space for soldering the LED packages 400 to the LED board 530 may be omitted. Accordingly, an arrangement of the LED packages 400 to reduce an Interval between the LED packages 400 or to contact the LED packages 400 with each other is possible, thereby minimizing a distance of the hot spots or preventing the generation of the hot spots, Accordingly, the LED package 400 in accordance with the present invention can reduce an outer size of the LCD panel 100 and increase an optical efficiency by reducing a distance of the blind area caused by the generation of the hot spots.

As described above, the LED package 400, and the backlight unit and the backlight unit including the LED package 400 in accordance with the present invention include the through-holes 432, through which the lead portions 414, including cathode and anode leads, extend. Such through-holes 414 are formed on the lateral surface of the housing 411 which is in contact with the LED board 530 in order to reduce the space required for soldering the LED packages 400 to the LED board 530.

Accordingly, it is possible to minimize the distance of the hot spots or prevent the generation of the hot spots, thus reducing the blind area caused by the hot spots. As a result, it is possible to reduce the outer size of the LCD panel 100 of the LCD device,

While the present invention has been shown and described with reference to some exemplary embodiments thereof, it will be understood by those of ordinary skill in the art that various changes in form and details may be made therein without departing from the spirit and scope of the present invention as defined by the appended claims.

## Claims

1. A light emitting diode package comprising:
at least one light emitting diode chip which emits light;
a housing defining a space for receiving the at least one light emitting diode chip, and the housing including a light emitting surface in an upper surface which collects the light emitted from the at least one light emitting diode chip and emits the same to an external environment; and
a lead portion, penetrating a lateral surface of the housing, one end of the lead portion is electrically connected to the at least one light emitting diode chip in the housing and another end of the lead portion is exposed to the external environment.

2. The light emitting diode package of claim 1, wherein the light emitting surface occupies more than about 95% of the entire upper surface area of the housing.

3. The light emitting diode package of claim 1, further comprising a wavelength conversion layer formed to cover the at least one light emitting diode chip in the housing and which generates white light using light emitted from the at least one light emitting diode chip.

4. The light emitting diode package of claim 3, wherein the at least one light emitting diode chip includes red and blue light emitting diodes, and the wavelength conversion layer comprises a green phosphor material.

5. The light emitting diode package of claim 3, wherein the at least one light emitting diode chip includes at least one blue light emitting diode, and the wavelength conversion layer comprises a yellow phosphor material.

6. The light emitting diode package of claim 1, wherein the lead portion has a shape selected from the group consisting of an " I " shape, a "T" shape, a "Z" shape and a combination including at least one of the foregoing shapes.

7. A light source unit comprising:
a light emitting diode board including an electrode pad for applying a driving voltage;
a housing mounted onto the light emitting diode board, the housing defining a space for receiving a plurality of light emitting diode chips which emit light, and the housing including a light emitting surface in an upper surface which collects the light emitted from the plurality of light emitting diode chips and emits the same to an external environment; and
a lead portion, penetrating a lateral surface of the housing, one end of the lead portion is electrically connected to the plurality of light emitting diode chips in the housing and another end of the lead portion is exposed to the external environment.

8. The light source unit of claim 7, wherein a plurality of light emitting diode packages is formed to be in contact with each other on the light emitting diode board.

9. The light source unit of claim 7, wherein a single light emitting diode package is mounted on the light emitting diode board.

10. The light source unit of claim 9, wherein the single light emitting diode package is formed with a same size as the light emitting diode board.

11. A backlight unit comprising:
a light source unit including a light emitting diode board including an electrode pad for applying a driving voltage, a housing mounted to the light emitting diode board, the housing defining a space for receiving a plurality of light emitting diode chips which emit light, and the housing including a light emitting surface in an upper surface which collects the light from the plurality of light emitting diode chips and emits the same to an external environment, and a lead portion which penetrates a lateral surface of the housing, one end of the lead portion is electrically connected to the plurality of light emitting diode chips in the housing and another end is exposed to the external environment; and
a light guide plate which converts a linear light emitted from the light source unit into a planar light.

12. The backlight unit of claim 11, wherein the light emitting surface of the housing is arranged to face the light guide plate.

13. The backlight unit of claim 11, wherein a plurality of light emitting diode packages is formed to be in contact with each other on the light emitting diode board.

14. The backlight unit of claim 13, wherein one side of the light emitting diode package includes a same length as a short side of the light guide plate,
